# EUROPEAN PATENT SPECIFICATION

(11) **EP 3 183 759 B1**
(45) Date of publication and mention of the grant of the patent: **26.09.2018**
(21) Application number: 15759399.7
(22) Date of filing: 17.08.2015
(51) Int. Cl.: H01L 27/32, H01L 51/54, G02B 5/02

(54) **LIGHT-EMITTING DEVICE**
LICHT EMITTIERENDE VORRICHTUNG
DISPOSITIF ÉMETTANT DE LUMIÈRE

(30) Priority: 22.08.2014 EP 14181891
(43) Date of publication of application: 28.06.2017
(73) Proprietor: OLEDWorks GmbH, 52068 Aachen (DE)
(72) Inventor: LIFKA, Herbert, NL-5656 AE Eindhoven (NL); VERBEEK, Roy Gerardus Franciscus Antonius, NL-5656 AE Eindhoven (NL); BOUTEN, Petrus Cornelis Paulus, NL-5656 AE Eindhoven (NL); VAN DE WEIJER, Peter, NL-5656 AE Eindhoven (NL); BEL, Matheus Godefridus Johannus, NL-5656 AE Eindhoven (NL); RUSKE, Manfred Stephan, NL-5656 AE Eindhoven (NL); GIERTH, Rainald Manfred, NL-5656 AE Eindhoven (NL); MEYER, Jens, NL-5656 AE Eindhoven (NL); GRABOWSKI, Stefan Peter, NL-5656 AE Eindhoven (NL); HUMMEL, Helga, NL-5656 AE Eindhoven (NL)
(74) Representative: Jostarndt Patentanwalts-AG
(86) International application number: PCT/EP2015/068807
(87) International publication number: WO 2016/026797

(56) References cited:
- EP-A1- 2 273 579
- EP-A1- 2 445 029
- WO-A1-2010/046833
- WO-A1-2014/012931
- JP-A- 2001 357 973
- US-A1- 2003 197 197
- US-A1- 2006 093 795
- US-A1- 2009 310 064
- US-A1- 2011 025 196

## Description

### FIELD OF THE INVENTION

The present invention relates to a light-emitting device, such as an organic light emitting device (OLED).

### BACKGROUND OF THE INVENTION

OLEDs are known to be extremely sensitive to moisture and oxygen, with major degradation effects occurring due to metal delamination, recrystallization of organic materials, reactions in metal and organic interfaces, and the like. An effective encapsulation to prevent the ingression of water and oxygen into the device is therefore required to achieve adequate lifetimes.

An established method for protecting non-flexible OLEDs is to make use of a conventional glass packaging with a material known as a "getter", which easily absorbs water and can hold a large volume of it, provided on the edge of the package outside the active OLED area. This rigid approach, however, does not work for flexible OLEDs, which are provided on flexible substrates made from polymers, such as plastic, metal foils, ultrathin glass, or the like. In this case, a thin-film encapsulation (TFE) comprising (a) transparent barrier layer(s) is typically used in place of the rigid glass packaging to effectively isolate the device from moisture and oxygen.

A problem with known transparent barrier layers for TFE is that they generally have inferior barrier properties to water and oxygen ingression compared to a conventional glass packaging. In some proposals, getter particles, for instance, calcium oxide (CaO), are dispersed in the transparent barrier layer. This, however, has the disadvantage that the transparent barrier layer will scatter light due to the presence of the dispersed getter particles. This scattering is also in some cases undesired if a top-emitting device provided on a non- flexible glass substrate is fabricated.

US2006/093795 A1 discloses a polymeric substrate for a moisture-sensitive electronic device including a polymeric support having a top and bottom surface, and a desiccant layer disposed over at least a portion of the top or bottom surface of the polymeric support, or both.

US2011/025196 A1 discloses organic light emitting devices including a transparent substrate, a first transparent electrode disposed on the transparent substrate, a second electrode, an electroluminescent layer sandwiched between the electrodes, and a getter layer disposed on a light emitting surface of the substrate opposite the first transparent electrode, and comprising a metal selected from beryllium, magnesium, calcium, strontium, barium, radium and titanium.

### SUMMARY OF THE INVENTION

It is an object of the present invention to provide a light-emitting device comprising a barrier layer, wherein the barrier layer has improved transparency characteristics while providing the desired getter functionality.

In a first aspect of the present invention, a light-emitting device is presented that comprises:
- a substrate,
- a current-light conversion arrangement comprising a current-light conversion material provided between a first electrode layer and a second electrode layer, and
- a barrier layer comprising a transparent organic layer provided between a first transparent inorganic barrier layer and a second transparent inorganic barrier layer.

The barrier layer is provided at a side of the current light-conversion arrangement opposite the substrate and/or between the substrate and the current light-conversion arrangement. Furthermore, a getter material is provided in the transparent organic layer in a pattern of getter dots.

The current-light conversion arrangement forms a structure with light-emitting regions and non-light-emitting regions of the current-light conversion material, wherein the barrier layer forms a mirror layer with non-transparent regions aligned to the light-emitting regions of the current-light conversion material and transparent regions aligned to the non-light-emitting regions of the current-light conversion material, wherein the non-transparent regions are formed by the getter dots.

According to this arrangement, the light-emitting device may at the same time be transparent (where the transparent regions are aligned with the non-light-emitting regions) and have a primary or even single direction of light emission (where the non-transparent regions block the light emission of their associated, aligned light-emitting regions). This is described in more detail in the published international patent application WO 2010/046833 A1 ("Transparent OLED Device"), the contents of which are incorporated herein by reference. Since the non-transparent regions, here, are formed by the getter dots, an additional getter functionality is achieved in a simple and efficient manner.

Since the getter material is provided in a pattern of getter dots, the light scattering effect resulting from dispersed getter particles can be avoided, resulting in improved transparency characteristics of the barrier layer while still providing the desired getter functionality. Moreover, since the getter material is provided in the transparent organic layer, that is, between the first and the second transparent inorganic barrier layer, an easier manufacture may be achieved compared to a case, where the getter material is provided directly on an electrode layer, in particular, a cathode layer, because the getter material may be reactive towards the material of the cathode layer.

The current-light conversion material is at least adapted to convert a current into light. It may comprise an organic current-light conversion material and/or an inorganic current-light conversion material. Moreover, it is possible that the current-light conversion material comprises multiple organic and/or inorganic materials or combinations thereof. For instance, in some cases, the current-light conversion material may comprise a perovskite (e.g., CH₃NH₃PbI₃).

The first electrode layer may be a transparent conductive anode layer, in particular, an indium tin oxide (ITO) anode layer, and the second electrode layer may a transparent conductive cathode layer, made, for instance, from silver (Ag). If the light-emitting device is, for instance, an OLED, when an electrical voltage is applied to the transparent conductive anode layer and the transparent conductive cathode layer, electrons and holes are injected into the organic current-light conversion material. When these recombine, light is emitted.

The transparent organic layer can be, for instance, a transparent polymer layer, and the first and the second transparent inorganic barrier layer can be made, for instance, from silicon nitride (SiN). Alternatively, a transparent inorganic barrier layer can also comprise a stack of inorganic layers, for instance, an SiN-SiON-SiN layer stack. The transparent organic layer has a function to ensure that pinholes in the two transparent inorganic barrier layers, which could let small traces of water into the current-light conversion device, do not join up.

It is also preferred that the first transparent inorganic barrier layer is provided closer to the substrate than the second transparent inorganic barrier layer, wherein the transparent organic layer comprises a transparent organic underlayer provided between the first transparent inorganic barrier layer and the getter dots. The transparent organic underlayer can provide an advantage during fabrication of the current-light conversion device, for instance, it can function as a transparent organic protection layer for mechanically protecting the first transparent inorganic barrier layer if the getter dots are provided through a screen mask, such as by means of physical vapor deposition (PVD) or sputtering or by means of screen printing (see below), or it can function as a transparent organic printing improvement layer for improving the printing of the getter dots if the getter dots are printed by means of inkjet printing (see below).

It is preferred that the first transparent inorganic barrier layer is provided closer to the substrate than the second transparent inorganic barrier layer, wherein the transparent organic layer comprises a transparent organic planarization layer that embeds the getter dots and forms a planar surface at a side opposite the first transparent inorganic barrier layer. This has the advantage that the transparent organic planarization layer provides a smooth surface, such that the subsequent layer, in particular, the second transparent inorganic barrier layer can be of higher quality.

It is preferred that the barrier layer comprises a further transparent organic layer provided between the first and the second transparent inorganic barrier layer, wherein the getter material is also provided in the further transparent organic layer in a pattern of getter dots, wherein a further transparent inorganic barrier layer is provided between the transparent organic layer and the further transparent organic layer. With this arrangement, the barrier properties of the barrier layer to water and oxygen ingression can be further improved by means of the further transparent inorganic barrier layer, which can also be made, for instance, from silicon nitride (SiN), or can comprise a stack of inorganic layers, for instance, an SiN-SiON-SiN layer stack. In addition, this arrangement can allow to provide more getter material without substantially increasing the fill factor of the getter dots.

It is further preferred that the getter dots have a fill factor of less than 20%, preferably less than 10%, most preferred less than 5%. The fill factor characterizes the density of the pattern of getter dots; it is defined as the ratio between the area covered by the getter dots and the total area. By means of the preferred fill factors, a sufficient transparency of the barrier layer can be achieved while still providing the desired getter functionality.

It is preferred that the height of the getter dots ranges from 10 nm to 20 µm and/or that the size of the getter dots ranges from 5 µm to 200 µm. For instance, if the getter dots are provided by means of a physical vapor deposition (PVD), the height of the getter dots may be rather limited, preferably, they may range from 10 nm to 500 nm, more preferred from 200 nm to 400 nm, most preferred 300 nm, due to the increased fabrication costs resulting from longer deposition times. In contrast, if the getter dots are provided by means of screen printing or inkjet printing, larger heights can be achieved more easily. In this case, they height of the getter dots may preferably range from 5 µm to 20 µm, more preferred 8 µm to 15 µm, most preferred, 10 µm to 12 µm.

It is preferred that the barrier layer is provided at a side of the current light-conversion arrangement opposite the substrate. This can preferably be used to fabricate top-emitting devices, wherein the barrier layer protects the light-emitting device, in particular, the current-light conversion arrangement, from the ingression of water and oxygen from the top side.

Additionally or alternatively, it is preferred that the barrier layer is provided between the substrate and the current light-conversion arrangement. Providing the barrier layer (also) between the substrate and the current light-conversion arrangement is particularly advantageous if the substrate is, for instance, a transparent polymer (plastic) substrate, which has an inferior barrier property to water and oxygen ingression compared to, for instance, a glass substrate. Therewith, bottom-emitting devices can be realized, wherein the barrier layer protects the light-emitting device, in particular, the current-light conversion arrangement, from the ingression of water and oxygen from the bottom side.

A configuration where a barrier layer is provided both at the side of the current light-conversion arrangement opposite the substrate and between the substrate and the current light-conversion arrangement, can preferably be used for fabricating flexible fully transparent light-emitting devices, wherein the barrier layers protect the light-emitting device, in particular, the current-light conversion arrangement, from the ingression of water and oxygen from both the top side and the bottom side.

A fabrication apparatus for fabricating a light-emitting device as definedabove may comprise:
- a substrate providing unit for providing a substrate,
- a current-light conversion arrangement providing unit for providing a current-light conversion arrangement comprising a current-light conversion material provided between a first and a second electrode layer, and
- a barrier layer providing unit for providing a barrier layer comprising a transparent organic layer provided between a first and a second transparent inorganic barrier layer,
wherein the fabrication apparatus is adapted to provide a getter material in the transparent organic layer in a pattern of getter dots.

The barrier layer providing unit may comprise:
- a first transparent inorganic barrier layer providing unit for providing a first transparent inorganic barrier layer,
- a transparent organic underlayer providing unit for providing a transparent organic underlayer, and
- a getter dots providing unit for providing the getter dots on the transparent organic underlayer through a screen mask.

Providing the getter dots through a screen mask, such as by means of physical vapor deposition (PVD) or sputtering or by means of screen printing, allows the getter dots to be provided in a simple manner. Moreover, by providing the transparent organic underlayer, a function of a transparent organic protection layer for protecting the first transparent inorganic barrier layer may be realized, such that damages, scratches and the like, which may occur on/in the first transparent inorganic barrier layer as a result of the use of the screen mask, may fully or partially be avoided.

As the getter material, a mixture of about 10% CaO dispersed in the same material that is used for the transparent organic layer is preferably used. However, other getter materials, such as barium oxide (BaO), calcium (Ca), certain salts and the like may also be employed.

The barrier layer providing unit may comprise a transparent organic planarization layer providing unit for providing a transparent organic planarization layer that embeds the getter dots and forms a planar surface at a side opposite the first transparent inorganic barrier layer.

The transparent organic planarization layer provides a smooth surface, such that the subsequent layer, in particular, the second transparent inorganic barrier layer can be of higher quality.

Alternatively, the barrier layer providing unit may comprise:
- a first transparent inorganic barrier layer providing unit for providing a first transparent inorganic barrier layer,
- a transparent organic underlayer providing unit for providing a transparent organic underlayer,
- a first processing unit for processing the transparent organic underlayer to make it more hydrophobic, and
- a getter dots printing unit for printing the getter dots on the more hydrophobic transparent organic underlayer by means of inkjet printing.

Making use of inkjet printing allows the getter dots to be provided in a simple manner. Moreover, by providing the transparent organic underlayer and by processing the transparent organic underlayer to make it more hydrophobic, that is, to reduce the ability of wetting of the transparent organic underlayer, a function as a transparent organic printing improvement layer for improving the printing of the getter dots can be realized, such that a tendency of the getter material to flow apart, which may result in an undesired increase of the size of the getter dots and/or a loss of the form thereof, may be reduced.

The first processing unit may comprise suitable means for generating a plasma, for instance, a tetrafluoromethane (CF₄) plasma with about 5% of oxygen (O₂), wherein the transparent organic underlayer is made more hydrophobic by processing it with the CF₄ plasma. Alternatively, a plasma based on, for instance, trifluoromethyl (CF₃) may be used or (a) primer(s), such as hexamethyldisilazane (HMDS), trichlorophenylsilane (TCPS) and the like, may be employed.

As the getter material, a mixture of about 10% CaO dispersed in the same material that is used for the transparent organic layer is preferably used. However, other getter materials, such as barium oxide (BaO), calcium (Ca), certain salts and the like may also be employed.

The barrier layer providing unit may further comprise:
- a second processing unit for processing the more hydrophobic transparent organic underlayer to make it more hydrophilic, and
- a transparent organic planarization layer providing unit for providing a transparent organic planarization layer that embeds the getter dots and forms a planar surface at a side opposite the first transparent inorganic barrier layer.

By processing the more hydrophobic transparent organic underlayer to make it more hydrophilic, the transparent organic planarization layer, which provides a smooth surface, such that the subsequent layer, in particular, the second transparent inorganic barrier layer can be of higher quality, can be provided with good quality.

The second processing unit may comprise suitable means for generating a plasma, for instance, an oxygen (O₂) plasma, wherein the more hydrophobic transparent organic underlayer is made more hydrophilic by processing it with the O₂ plasma. Alternatively, for instance, a UV-ozone may be employed.

It is preferred that a getter dot is printed as a stack of two or more layers of getter material. By doing so, higher getter dots having more getter capacity can be provided. This may be particularly simple due to the hydrophobic properties of the processed transparent organic underlayer (see above), which allow the getter material of the two or more layers to align itself locally.

A fabrication method for fabricating a light-emitting device as defined above may comprise the steps of:
- providing a substrate,
- providing a current-light conversion arrangement comprising a current-light conversion material provided between a first and a second electrode layer, and
- providing a barrier layer comprising a transparent organic layer provided between a first and a second transparent inorganic barrier layer,
wherein the fabrication method provides a getter material in the transparent organic layer in a pattern of getter dots.

It shall be understood that a preferred embodiment of the present invention can also be any combination of the dependent claims or of the following embodiments with the respective independent claim.

These and other aspects of the invention will be apparent from and elucidated with reference to the embodiments described hereinafter.

### BRIEF DESCRIPTION OF THE DRAWINGS

In the following drawings:
Fig. 1 shows schematically and exemplarily a first embodiment, useful for understanding the invention, of a light-emitting device, here, an OLED,
Fig. 2 shows schematically and exemplarily a second embodiment, useful for understanding the invention, of a light-emitting device, here, an OLED,
Fig. 3 shows a barrier layer as a variant of one or more of the barrier layers comprised by the OLEDs shown in Figs. 1 and 2,
Fig. 4 shows schematically and exemplarily a first example of a fabrication apparatus for fabricating a light-emitting device, here, the OLED shown in Fig. 1,
Fig. 5 shows schematically and exemplarily a second example of a fabrication apparatus for fabricating a light-emitting device, here, the OLED shown in Fig. 1,
Fig. 6 shows a flowchart exemplarily illustrating a first example of a fabrication method for fabricating a light-emitting device, here, the OLED shown in Fig. 1,
Fig. 7 shows a flowchart exemplarily illustrating a second example of a fabrication method for fabricating a light-emitting device, here, the OLED shown in Fig. 1, and
Fig. 8 shows a further use of the getter dots that are employed in the inventive OLED, for which the OLEDs shown in Figs. 1 and 2 are modified to comprise a barrier layer forming a mirror with non-transparent regions aligned to the light--emitting regions.

### DETAILED DESCRIPTION OF EMBODIMENTS

In the drawings, like or corresponding reference numerals refer to like or corresponding parts and/or elements.

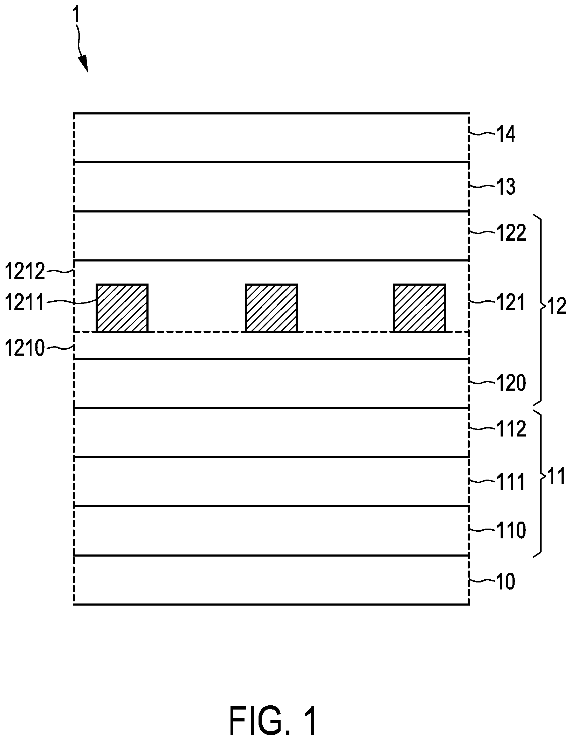

Fig. 1 shows schematically and examplarily a first embodiment of a light-emitting device 1, here, an OLED. The dashed lines at the sides of the OLED 1 indicate that the figure only shows a section of the complete device.

The OLED 1 comprises a substrate 10, in this embodiment, a glass substrate, which has a barrier property to water and oxygen ingression, and a current-light conversion arrangement 11 arranged on the glass substrate 10. The current-light conversion arrangement 11 comprises a current-light conversion material 111, here, an organic current-light conversion material, which is adapted to convert a current into light, provided between a first and a second electrode layer 110, 112. In this embodiment, the first electrode layer 110 is a transparent conductive anode layer, in particular, an indium tin oxide (ITO) anode layer, and the second electrode layer 112 is a transparent conductive cathode layer, made, for instance, from silver (Ag). When an electrical voltage is applied to the transparent conductive anode layer 110 and the transparent conductive cathode layer 112, electrons and holes are injected into the organic current-light conversion material 111. When these recombine, light is emitted.

In order to protect the OLED 1, in particular, the current-light conversion arrangement 11, from the ingression of water and oxygen, the OLED 1 further comprises a barrier layer 12 provided on the current-light conversion arrangement 11. The barrier layer 12, here, comprises a transparent organic layer 121, for instance, a transparent polymer layer, provided between a first and a second transparent inorganic barrier layer 120, 122, made from silicon nitride (SiN). The transparent organic layer 121 has a function to ensure that pinholes in the two transparent inorganic barrier layers 120, 122, which could let small traces of water into the OLED 1, do not join up.

In this embodiment, the OLED 1 further comprises a transparent topcoating 13 provided on the barrier layer 12 and a transparent protecting foil 14 provided on the transparent topcoating 13.

In order to further improve the barrier properties of the barrier layer 12 to water and oxygen ingression, a getter material is provided in the transparent organic layer 121 in a pattern of getter dots 1211.

Here, the first transparent inorganic barrier layer 120 is provided closer to the substrate 10 than the second transparent inorganic barrier layer 122. The transparent organic layer 121 comprises a transparent organic underlayer 1210 provided between the first transparent inorganic barrier layer 120 and the getter dots 1211 and a transparent organic planarization layer 1212 that embeds the getter dots 1211 and forms a planar surface at a side opposite the first transparent inorganic barrier layer 120. The transparent organic planarization layer 1212 provides a smooth surface, such that the subsequent layer, in particular, the second transparent inorganic barrier layer 122 can be of higher quality.

In this embodiment, the glass substrate 10 already provides a sufficient protection of the OLED 1, in particular, the current-light conversion arrangement 11, from the ingression of water and oxygen from the bottom side. The barrier layer 12 is therefore only provided at a side of the current light-conversion arrangement 11 opposite the glass substrate 10, such as to protect the OLED 1 from the ingression of water and oxygen from the top side, that is, through the transparent protecting foil 14 and the transparent topcoating 13.

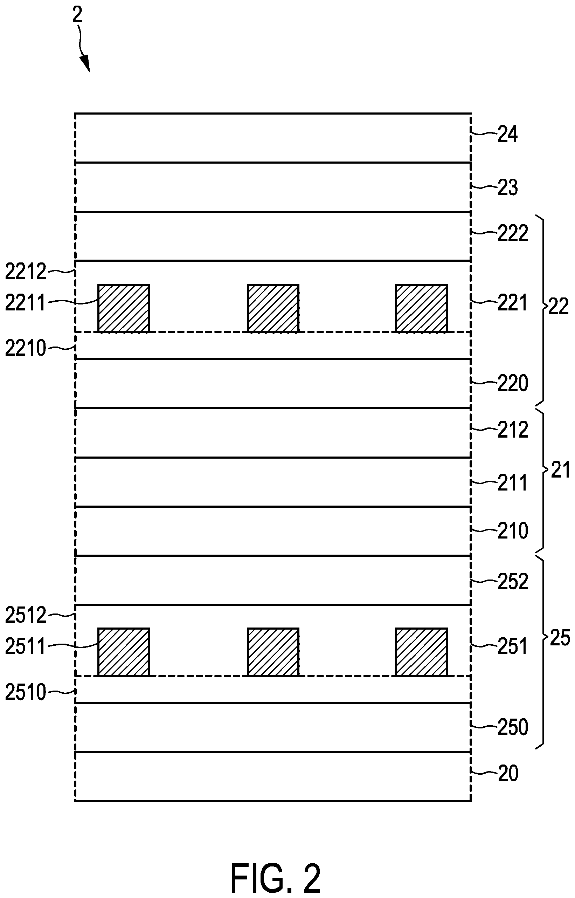

Fig. 2 shows schematically and examplarily a second embodiment of a light-emitting device 2, here, an OLED. The dashed lines at the sides of the OLED 2 indicate that the figure only shows a section of the complete device.

The OLED 2 is structurally quite similar to the OLED 1 shown in Fig. 1. As in this figure, the OLED 2 comprises a substrate 20, a current-light conversion arrangement 21 provided on the substrate 20, and a barrier layer 22 provided on the current-light conversion arrangement 21. The current-light conversion arrangement 21 comprises a current-light conversion material 211, here, an organic current-light conversion material, which is adapted to convert a current into light, provided between a first and a second electrode layer 210, 212. In this embodiment, the first electrode layer 210 is a transparent conductive anode layer, in particular, an indium tin oxide (ITO) anode layer, and the second electrode layer 212 is a transparent conductive cathode layer, made, for instance, from silver (Ag). The barrier layer 22, here, comprises a transparent organic layer 221, for instance, a transparent polymer layer, provided between a first and a second transparent inorganic barrier layer 220, 222, made from silicon nitride (SiN). The transparent organic layer 221 has a function to ensure that pinholes in the two transparent inorganic barrier layers 220, 222, which could let small traces of water into the OLED 2, do not join up.

In this embodiment, the OLED 2 further comprises a transparent topcoating 23 provided on the barrier layer 22 and a transparent protecting foil 24 provided on the transparent topcoating 23.

In order to further improve the barrier properties of the barrier layer 22 to water and oxygen ingression, a getter material is provided in the transparent organic layer 221 in a pattern of getter dots 2211.

Here, the first transparent inorganic barrier layer 220 is provided closer to the substrate 20 than the second transparent inorganic barrier layer 222. The transparent organic layer 221 comprises a transparent organic underlayer 2210 provided between the first transparent inorganic barrier layer 220 and the getter dots 2211 and a transparent organic planarization layer 2212 that embeds the getter dots 2211 and forms a planar surface at a side opposite the first transparent inorganic barrier layer 220. The transparent organic planarization layer 2212 provides a smooth surface, such that the subsequent layer, in particular, the second transparent inorganic barrier layer 222 can be of higher quality.

While the OLED 2, as described so far, corresponds to the OLED 1 shown in Fig. 1, this embodiment, however, differs from the first embodiment in that the substrate 20 is a transparent polymer (plastic) substrate, which has an inferior barrier property to water and oxygen ingression compared to the glass substrate 10 comprised by the OLED 1. For this reason, an additional barrier layer 25 is provided between the substrate 20 and the current light-conversion arrangement 21. The structure of the additional barrier layer 25, here, is the same as the structure of the barrier layer 22, i.e., the additional barrier layer 25 comprises a transparent organic layer 251, for instance, a transparent polymer layer, provided between a first and a second transparent inorganic barrier layer 250, 252, made from silicon nitride (SiN). The transparent organic layer 251 has a function to ensure that pinholes in the two transparent inorganic barrier layers 250, 252, which could let small traces of water into the OLED 2, do not join up. In the barrier layer 25, a getter material is likewise provided in the transparent organic layer 251 in a pattern of getter dots 2511. Furthermore, also the first transparent inorganic barrier layer 250 is provided closer to the substrate 20 than the second transparent inorganic barrier layer 252 and the transparent organic layer 251 comprises a transparent organic underlayer 2510 provided between the first transparent inorganic barrier layer 250 and the getter dots 2510 and a transparent organic planarization layer 2512 that embeds the getter dots 2511 and forms a planar surface at a side opposite the first transparent inorganic barrier layer 250. The transparent organic planarization layer 2512 provides a smooth surface, such that the subsequent layer, in particular, the second transparent inorganic barrier layer 252 can be of higher quality.

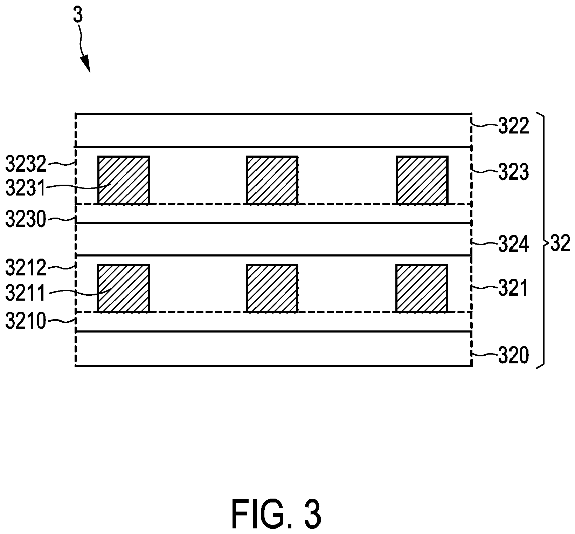

Fig. 3 shows a barrier layer 32 as a variant of one or more of the barrier layers 12, 22, 25 comprised by the OLEDs 1, 2 shown in Figs. 1 and 2. The dashed lines at the sides of the barrier layer 32 indicate that the figure only shows a section of the complete layer.

The barrier layer 32 is structurally quite similar to the barrier layers 12, 22, 25. In particular, it also comprises a transparent organic layer 321, for instance, a transparent polymer layer, provided between a first and a second transparent inorganic barrier layer 320, 322, made from silicon nitride (SiN). Likewise, a getter material is provided in the transparent organic layer 321 in a pattern of getter dots 3211. In this variant, however, the barrier layer 32 comprises a further transparent organic layer 323, for instance, a further transparent polymer layer, provided between the first and the second transparent inorganic barrier layer 320, 322, and the getter material is also provided in the further transparent organic layer in a pattern of getter dots 3231. Moreover, a further transparent inorganic barrier layer 324, made from silicon nitride (SiN), is provided between the transparent organic layer 321 and the further transparent organic layer 323. With this arrangement, the barrier properties of the barrier layer 32 to water and oxygen ingression can be further improved by means of the further transparent inorganic barrier layer 324. In addition, this arrangement can allow to provide more getter material without substantially increasing the fill factor of the getter dots 3211, 3231.

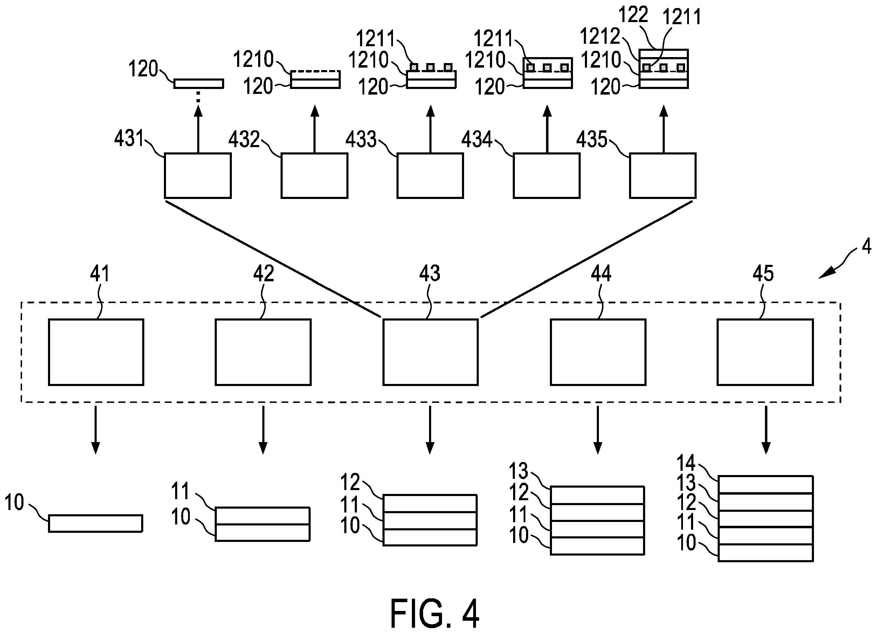

Fig. 4 shows schematically and exemplarily a first example of a fabrication apparatus 4 for fabricating a light-emitting device, here, the OLED 1 shown in Fig. 1.

The fabrication apparatus 4 comprises a substrate providing unit 41 for providing a substrate 10, here, a glass substrate, which has a barrier property to water and oxygen ingression. The fabrication apparatus 4 further comprises a current-light conversion arrangement providing unit 42 for providing a current-light conversion arrangement 11 on the glass substrate 10. The current-light conversion arrangement 11 comprises a current-light conversion material 111, here, an organic current-light conversion material, which is adapted to convert a current into light, provided between a first and a second electrode layer 110, 112 (all not shown in detail in this figure). In this example, the first electrode layer 110 is a transparent conductive anode layer, in particular, an indium tin oxide (ITO) anode layer, and the second electrode layer 112 is a transparent conductive cathode layer, made, for instance, from silver (Ag). When an electrical voltage is applied to the transparent conductive anode layer 110 and the transparent conductive cathode layer 112, electrons and holes are injected into the organic current-light conversion material 111. When these recombine, light is emitted.

The fabrication apparatus 4 further comprises a barrier layer providing unit 43 for providing a barrier layer 12, here, comprising a transparent organic layer 121, for instance, a transparent polymer layer, provided between a first and a second transparent inorganic barrier layer 120, 122, made from silicon nitride (SiN). The transparent organic layer 121 has a function to ensure that pinholes in the two transparent inorganic barrier layers 120, 122, which could let small traces of water into the OLED 1, do not join up.

In this example, the fabrication apparatus 4 further comprises a transparent topcoating providing unit 44 for providing a transparent topcoating 13. The fabrication apparatus 4 further comprises a transparent protecting foil providing unit 45 for providing a transparent protecting foil 14.

The fabrication apparatus 4 is adapted to provide a getter material in the transparent organic layer 121 in a pattern of getter dots 1211.

In this example, the barrier layer providing unit 43 comprises a first transparent inorganic barrier layer providing unit 431 for providing the first transparent inorganic barrier layer 120. The barrier layer providing unit 43 further comprises a transparent organic underlayer providing unit 432 for providing a transparent organic underlayer 1210. The barrier layer providing unit 43 further comprises a getter dots providing unit 433 for providing the getter dots 1211 on the transparent organic underlayer 1210 through a screen mask (not shown in the figure), here, by means of screen printing. Here, a mixture of about 10% CaO dispersed in the same material that is used for the transparent organic layer 121 is preferably used as the getter material.

The barrier layer providing unit 43, here, further comprises a transparent organic planarization layer providing unit 434 for providing a transparent organic planarization layer 1212 that embeds the getter dots 1211 and forms a planar surface at a side opposite the first transparent inorganic barrier layer 120. The barrier layer providing unit 43 further comprises a second transparent inorganic barrier layer providing unit 435 for providing the second transparent inorganic barrier layer 122.

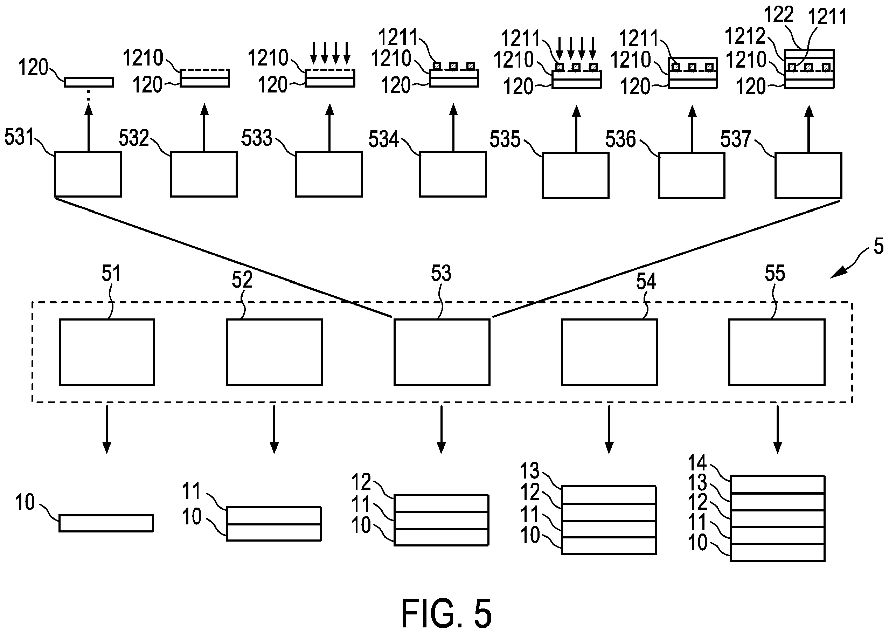

Fig. 5 shows schematically and exemplarily a second example of a fabrication apparatus 5 for fabricating a light-emitting device, here, the OLED 1 shown in Fig. 1.

The fabrication apparatus 5 comprises a substrate providing unit 51 for providing a substrate 10, here, a glass substrate, which has a barrier property to water and oxygen ingression. The fabrication apparatus 5 further comprises a current-light conversion arrangement providing unit 52 for providing a current-light conversion arrangement 11 on the glass substrate 10. The current-light conversion arrangement 11 comprises a current-light conversion material 111, here, an organic current-light conversion material, which is adapted to convert a current into light, provided between a first and a second electrode layer 110, 112 (all not shown in detail in this figure). In this example, the first electrode layer 110 is a transparent conductive anode layer, in particular, an indium tin oxide (ITO) anode layer, and the second electrode layer 112 is a transparent conductive cathode layer, made, for instance, from silver (Ag). When an electrical voltage is applied to the transparent conductive anode layer 110 and the transparent conductive cathode layer 112, electrons and holes are injected into the organic current-light conversion material 111. When these recombine, light is emitted.

The fabrication apparatus 5 further comprises a barrier layer providing unit 53 for providing a barrier layer 12, here, comprising a transparent organic layer 121, for instance, a transparent polymer layer, provided between a first and a second transparent inorganic barrier layer 120, 122, made from silicon nitride (SiN). The transparent organic layer 121 has a function to ensure that pinholes in the two transparent inorganic barrier layers 120, 122, which could let small traces of water into the OLED 1, do not join up.

In this example, the fabrication apparatus 5 further comprises a transparent topcoating providing unit 54 for providing a transparent topcoating 13. The fabrication apparatus 4 further comprises a transparent protecting foil providing unit 55 for providing a transparent protecting foil 14.

The fabrication apparatus 5 is adapted to provide a getter material in the transparent organic layer 121 in a pattern of getter dots 1211.

In this example, the barrier layer providing unit 53 comprises a first transparent inorganic barrier layer providing unit 531 for providing the first transparent inorganic barrier layer 120. The barrier layer providing unit 53 further comprises a transparent organic underlayer providing unit 532 for providing a transparent organic underlayer 1210. The barrier layer providing unit 53 further comprises a first processing unit for processing the transparent organic underlayer 1210 to make it more hydrophobic and a getter dots printing unit 534 for printing the getter dots 1211 on the more hydrophobic transparent organic underlayer 1210 by means of inkjet printing. In this example, the first processing unit 534 comprises suitable means for generating a plasma, for instance, a tetrafluoromethane (CF₄) plasma with about 5% of oxygen (O₂), wherein the transparent organic underlayer 1210 is made more hydrophobic by processing it with the CF₄ plasma. Here, a mixture of about 10% CaO dispersed in the same material that is used for the transparent organic layer 121 is preferably used as the getter material.

The barrier layer providing unit 53, here, further comprises a second processing unit 535 for processing the more hydrophobic transparent organic underlayer 1210 to make it more hydrophilic and a transparent organic planarization layer providing unit 536 for providing a transparent organic planarization layer 1212 that embeds the getter dots 1211 and forms a planar surface at a side opposite the first transparent inorganic barrier layer 120. In this example, the second processing unit 535 comprises suitable means for generating a plasma, for instance, an oxygen (O₂) plasma, wherein the more hydrophobic transparent organic underlayer 1210 is made more hydrophilic by processing it with the O₂ plasma. The barrier layer providing unit 53 further comprises a second transparent inorganic barrier layer providing unit 537 for providing the second transparent inorganic barrier layer 122.

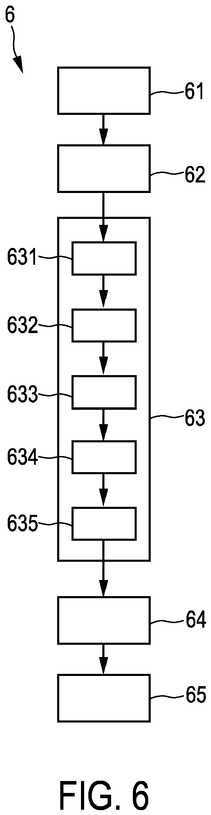

In the following, a first example of a fabrication method 6 for fabricating a light-emitting device, here, the OLED 1 shown in Fig. 1, will exemplarily be described with reference to the flowchart shown in Fig. 6.

In step 61, a substrate 10, here, a glass substrate, which has a barrier property to water and oxygen ingression, is provided. In step 62, a current-light conversion arrangement 11 is provided on the glass substrate 10. The current-light conversion arrangement 11 comprises a current-light conversion material 111, here, an organic current-light conversion material, which is adapted to convert a current into light, provided between a first and a second electrode layer 110, 112 (all not shown in detail in this figure). In this example, the first electrode layer 110 is a transparent conductive anode layer, in particular, an indium tin oxide (ITO) anode layer, and the second electrode layer 112 is a transparent conductive cathode layer, made, for instance, from silver (Ag). When an electrical voltage is applied to the transparent conductive anode layer 110 and the transparent conductive cathode layer 112, electrons and holes are injected into the organic current-light conversion material 111. When these recombine, light is emitted.

In step 63, a barrier layer 12, here, comprising a transparent organic layer 121, for instance, a transparent polymer layer, provided between a first and a second transparent inorganic barrier layer 120, 122, made from silicon nitride (SiN), is provided. The transparent organic layer 121 has a function to ensure that pinholes in the two transparent inorganic barrier layers 120, 122, which could let small traces of water into the OLED 1, do not join up.

In this example, a transparent topcoating 13 is provided in step 64 and a transparent protecting foil 14 is provided in step 65.

The fabrication method 6 provides a getter material in the transparent organic layer 121 in a pattern of getter dots 1211.In this example, the barrier layer providing step 63 comprises providing 631 the first transparent inorganic barrier layer 120. The barrier layer providing step 63 further comprises providing 632 a transparent organic underlayer 1210. The barrier layer providing step 63 further comprises providing 633 the getter dots 1211 on the transparent organic underlayer 1210 through a screen mask (not shown in the figure), here, by means of screen printing. Here, a mixture of about 10% CaO dispersed in the same material that is used for the transparent organic layer 121 is preferably used as the getter material.

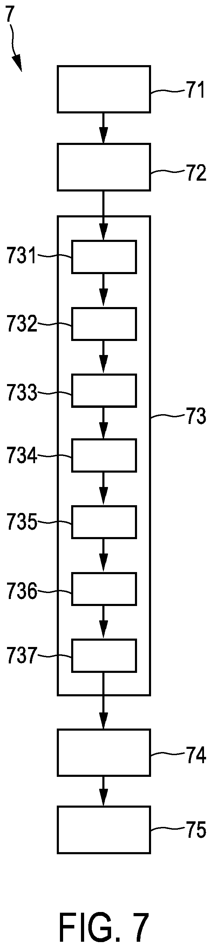

The barrier layer providing step 63, here, further comprises providing 634 a transparent organic planarization layer 1212 that embeds the getter dots 1211 and forms a planar surface at a side opposite the first transparent inorganic barrier layer 120. The barrier layer providing step 63 further comprises providing 635 the second transparent inorganic barrier layer 122.Fig. 7 shows schematically and exemplarily a second example of a fabrication method 7 for fabricating a light-emitting device, here, the OLED 1 shown in Fig. 1.

In step 71, a substrate 10, here, a glass substrate, which has a barrier property to water and oxygen ingression, is provided. In step 72, a current-light conversion arrangement 11 is provided on the glass substrate 10. The current-light conversion arrangement 11 comprises a current-light conversion material 111, here, an organic current-light conversion material, which is adapted to convert a current into light, provided between a first and a second electrode layer 110, 112 (all not shown in detail in this figure). In this example, the first electrode layer 110 is a transparent conductive anode layer, in particular, an indium tin oxide (ITO) anode layer, and the second electrode layer 112 is a transparent conductive cathode layer, made, for instance, from silver (Ag). When an electrical voltage is applied to the transparent conductive anode layer 110 and the transparent conductive cathode layer 112, electrons and holes are injected into the organic current-light conversion material 111. When these recombine, light is emitted.

In step 73, a barrier layer 12, here, comprising a transparent organic layer 121, for instance, a transparent polymer layer, provided between a first and a second transparent inorganic barrier layer 120, 122, made from silicon nitride (SiN), is provided. The transparent organic layer 121 has a function to ensure that pinholes in the two transparent inorganic barrier layers 120, 122, which could let small traces of water into the OLED 1, do not join up.

In this example, a transparent topcoating 13 is provided in step 74 and a transparent protecting foil 14 is provided in step 75.

The fabrication method 7 provides a getter material in the transparent organic layer 121 in a pattern of getter dots 1211.

In this example, the barrier layer providing step 73 comprises providing 731 the first transparent inorganic barrier layer 120. The barrier layer providing step 73 further comprises providing 732 a transparent organic underlayer 1210. The barrier layer providing step 73 further comprises a first processing 733 of the transparent organic underlayer 1210 to make it more hydrophobic and printing 734 the getter dots 1211 on the more hydrophobic transparent organic underlayer 1210 by means of inkjet printing. In this example, the first processing step 733 comprises suitably generating a plasma, for instance, a tetrafluoromethane (CF₄) plasma with about 5% of oxygen (O₂), wherein the transparent organic underlayer 1210 is made more hydrophobic by processing it with the CF₄ plasma. Here, a mixture of about 10% CaO dispersed in the same material that is used for the transparent organic layer 121 is preferably used as the getter material.

The barrier layer providing step 73, here, further comprises a second processing 735 of the more hydrophobic transparent organic underlayer 1210 to make it more hydrophilic and providing 736 a transparent organic planarization layer 1212 that embeds the getter dots 1211 and forms a planar surface at a side opposite the first transparent inorganic barrier layer 120. In this example, the second processing step 735 comprises suitable suitably generating a plasma, for instance, an oxygen (O₂) plasma, wherein the more hydrophobic transparent organic underlayer 1210 is made more hydrophilic by processing it with the O₂ plasma. The barrier layer providing step 73 further comprises providing the second transparent inorganic barrier layer 122.

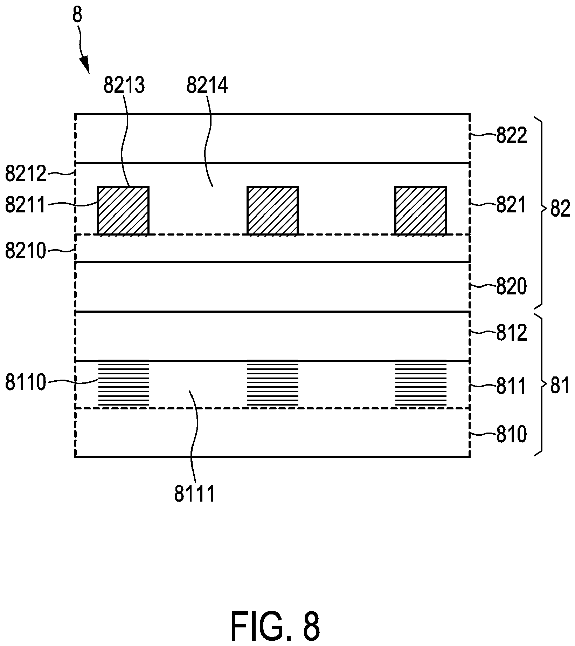

Fig. 8 shows a further use of the getter dots that are employed in the OLEDs shown in Figs. 1 and 2. Here, the current-light conversion arrangement 81 forms a structure with light-emitting regions 8110 and non-light-emitting regions 8111 of the current-light conversion material 811 and the barrier layer 82 forms a mirror layer with non-transparent regions 8213 aligned to the light-emitting regions 8110 of the current-light conversion material 811 and transparent regions 8214 aligned to the non-light-emitting regions 8111 of the current-light conversion material 811. The non-transparent regions 8213 are formed, here, by the getter dots 8211. According to this arrangement, the light-emitting device may at the same time be transparent (where the transparent regions 8214 are aligned with the non-light-emitting regions 8111) and have a primary or even single direction of light emission (where the non-transparent regions 8213 block the light emission of their associated, aligned light-emitting regions 8110). This is described in more detail in the published international patent application WO 2010/046833 A1 ("Transparent OLED Device"), the contents of which are incorporated herein by reference. Since the non-transparent regions 8213, here, are formed by the getter dots 8211, an additional getter functionality is achieved in a simple and efficient manner.

In the first and the second embodiment of a light-emitting device 1, 2 described with reference to Figs. 1 to 3 above, the second transparent inorganic barrier layers 122, 222, 252, 322 preferably cover the edges of the respective transparent organic layers 121, 221, 251, 321. Moreover, the transparent topcoatings 13, 23 and the transparent protecting foils 14, 24 preferably cover at least the area of the respective transparent organic layers 121, 221, 251, 321.

While in the first and the second embodiment of a light-emitting device 1, 2 described with reference to Figs. 1 to 3 above, the first and the second transparent inorganic barrier layer 120, 122, 220, 250, 222, 252, 320, 322 as well as the further inorganic barrier layer 324 have been described as being made from SiN, a transparent inorganic barrier layer can also comprise a stack of inorganic layers, for instance, an SiN-SiON-SiN layer stack.

While in the first and the second embodiment of a light-emitting device 1, 2 described with reference to Figs. 1 and 2 above, the OLEDs 1, 2 comprise both a transparent topcoating 13, 23 and a transparent protecting foil 14, 24, in other embodiments, only a transparent topcoating or only a transparent protecting foil or none of these structures may be provided.

While in the first and the second examples of a fabrication method 6, 7 for fabricating a light-emitting device described with reference to Figs. 6 and 7, the fabricated OLED 1 has a configuration where a barrier layer 12 is provided at a side of the current light-conversion arrangement 11 opposite the substrate 10, in other examples, the fabricated light-emitting device may also have a configuration where, additionally or alternatively, a barrier layer is provided between the substrate and the current light-conversion arrangement (see Fig. 2). The barrier layer providing step 63, 73 is not required to occur after the current-light conversion arrangement providing step 62, 72. Rather, the barrier layer providing step 63, 73 may occur before the current-light conversion arrangement providing step 62, 72 and there may be provided an additional barrier layer providing step that occurs after the conversion arrangement providing step 62, 72. The same applies analogously also to the first and the second examples of a fabrication apparatus 4, 5 for fabricating a light-emitting device described with reference to Figs. 4 and 5.

The transparent organic underlayer 10, 2210, 2510, 3210, 8210 does not have to be provided in all embodiments of a light-emitting device. For instance, if the getter dots are provided by means of a physical vapor deposition (PVD) of the getter material, preferably CaO, a mechanical protection of the first transparent inorganic barrier layer may not be necessary.

If the transparent organic layer comprises a transparent organic planarization layer, the transparent organic planarization layer may completely cover the getter dots, that is, the planar surface at the side opposite the first transparent inorganic barrier layer may completely be formed by the transparent organic planarization layer. It may, however, also be possible that the planar surface is formed by the top surfaces of the getter dots and the transparent organic planarization layer, that is, that the transparent organic planarization layer is provided up to the same height as the getter dots.

It shall be noted that in addition to the getter dots, a rim made from getter material may be provided in the transparent organic layer to surround the "active area" of the light-emitting device. Such a getter rim can be fabricated using substantially the same methods as described above. For instance, it can be provided by means of inkjet printing.

While in the structure shown in Fig. 8, the non-transparent regions 8213 are formed by the getter dots 8211, it can be advantageous if an additional non-transparent material that is substantially non-sensitive to water and oxygen, for instance, an additional metal layer, is provided below or above the getter dots (not shown in the figure). In this way, the desired non-transparency of the non-transparent regions, here formed by the getter dots and the additional material, can be ensured even if the getter dots degrade as a result of the ingression of water and oxygen.

In the claims, the word "comprising" does not exclude other elements or steps, and the indefinite article "a" or "an" does not exclude a plurality.

A single unit or device may fulfill the functions of several items recited in the claims. The mere fact that certain measures are recited in mutually different dependent claims does not indicate that a combination of these measures cannot be used to advantage.

Any reference signs in the claims should not be construed as limiting the scope.

## Claims

1. A light-emitting device (1; 2) comprising:
- a substrate (10; 20),
- a current-light conversion arrangement (11; 21; 81) comprising a current-light conversion material (111; 211; 811) provided between a first electrode layer (110; 210; 810) and a second electrode layer (112; 212; 812), and
- a barrier layer (12; 22, 25; 32; 82) comprising a transparent organic layer (121; 221, 251; 321; 821) provided between a first transparent inorganic barrier layer (120; 220; 250; 320; 820) and a second transparent inorganic barrier layer (122; 222, 252; 322; 822), the barrier layer (12; 22, 25; 32; 82) being provided at a side of the current light-conversion arrangement (11; 21; 81) opposite the substrate (10; 20) and/or between the substrate (10; 20) and the current light-conversion arrangement (11; 21; 81),
wherein a getter material is provided in the transparent organic layer (121; 221, 251; 321; 821) in a pattern of getter dots (1211; 2211, 2511; 3211; 8211),
**characterized in that**
the current-light conversion arrangement (11; 21; 81) forms a structure with light-emitting regions (8110) and non-light-emitting regions (8111) of the current-light conversion material (811),
wherein the barrier layer (12; 22, 25; 32; 82) forms a mirror layer with nontransparent regions (8213) aligned to the light-emitting regions (8110) of the current-light conversion material (811) and transparent regions (8214) aligned to the non-light-emitting regions (8111) of the current-light conversion material (811), and
wherein the non-transparent regions (8213) are formed by the getter dots (1211; 2211, 2511; 3211; 8211).

2. The light-emitting device (1; 2) as defined in claim 1, wherein the first transparent inorganic barrier layer (120; 220, 250; 320; 820) is provided closer to the substrate (10; 20) than the second transparent inorganic barrier layer (122; 222, 252; 322; 822), wherein the transparent organic layer (121; 221, 251; 321; 821) comprises a transparent organic underlayer (1210; 2210, 2510; 3210; 8210) provided between the first transparent inorganic barrier layer (120; 220, 250; 320; 820) and the getter dots (1211; 2211, 2511; 3211; 8211).

3. The light-emitting device (1; 2) as defined in claim 1, wherein the first transparent inorganic barrier layer (120; 220, 250; 320; 820) is provided closer to the substrate (10; 20) than the second transparent inorganic barrier layer (122; 222, 252; 322; 822), wherein the transparent organic layer (121; 221, 251; 321; 821) comprises a transparent organic planarization layer (1212; 2212, 2512; 3212; 8212) that embeds the getter dots (1211; 2211, 2511; 3211; 8211) and forms a planar surface at a side opposite the first transparent inorganic barrier layer (120; 220, 250; 320; 820).

4. The light-emitting device (1; 2) as defined in claim 1, wherein the barrier layer (32) comprises a further transparent organic layer (323) provided between the first transparent inorganic barrier layer (320) and the second transparent inorganic barrier layer (322), wherein the getter material is also provided in the further transparent organic layer (323) in a pattern of getter dots (3231), wherein a further transparent inorganic barrier layer (324) is provided between the transparent organic layer (321) and the further transparent organic layer (323).

5. The light-emitting device (1; 2) as defined in claim 1, wherein the getter dots (1211; 2211, 2511; 3211; 8211) have a fill factor of less than 20%, preferably less than 10%, most preferred less than 5%.

6. The light-emitting device (1; 2) as defined in claim 1, wherein the height of the getter dots (1211; 2211, 2511; 3211; 8211) ranges from 10 nm to 20 µm and/or wherein the size of the getter dots (1211; 2211, 2511; 3211; 8211) ranges from 5 µm to 200 µm.

## Patentansprüche

1. Licht-emittierende Vorrichtung (1; 2), aufweisend:
- ein Substrat (10; 20),
- eine Strom-Licht Konversionsanordnung (11; 21; 81) aufweisend ein Strom-Licht Konversionsmaterial (111; 211; 811), die zwischen einer ersten Elektrodenschicht (110; 210; 810) und einer zweiten Elektrodenschicht (112; 212; 812) bereitgestellt ist, und
- eine Sperrschicht (12; 22, 25; 32; 82) aufweisend eine transparente organische Schicht (121; 221, 251; 321; 821), die zwischen einer ersten transparenten anorganischen Sperrschicht (120; 220; 250; 320; 820) und einer zweiten anorganischen Sperrschicht (122; 222, 252; 322; 822) bereitgestellt ist, wobei die Sperrschicht (12; 22, 25; 32; 82) auf einer Seite der Strom-Licht Konversionsanordnung (11; 21; 81), die dem Substrat (10; 20) gegenüberliegt, und/oder zwischen dem Substrat (10; 20) und der Strom-Licht Konversionsanordnung (11; 21; 81) bereitgestellt ist,
wobei ein Gettermaterial in der transparenten organischen Schicht (121; 221, 251; 321; 821) in einem Muster von Getter-Punkten (1211; 2211, 2511; 3211; 8211) bereitgestellt ist,
**dadurch gekennzeichnet, dass**
die Strom-Licht Konversionsanordnung (11; 21; 81) eine Struktur mit Licht-emittierenden Bereichen (8110) und nicht Licht-emittierenden Bereichen (8111) des Strom-Licht-Konversionsmaterials (811) bildet,
wobei die Sperrschicht (12; 22, 25; 32; 82) eine Spiegelschicht mit nichttransparenten Bereichen (8213), die an den lichtemittierenden Bereichen (8110) des Strom-Licht-Konversionsmaterials (811) ausgerichtet ist, und mit transparenten Bereichen, die an den nicht-Licht-emittierenden Bereichen (8111) des Strom-Licht-Konversionsmaterials (811) ausgerichtet sind, bildet, und
wobei die nichttransparenten Bereiche (8213) durch die Getter-Punkte (1211; 2211, 2511; 3211; 8211) gebildet werden.

2. Licht-emittierende Vorrichtung (1; 2) nach Anspruch 1, wobei die erste transparente anorganische Sperrschicht (120; 220, 250; 320; 820) näher an dem Substrat (10; 20) bereitgestellt ist als die zweite transparente anorganische Sperrschicht (122; 222, 252; 322; 822), wobei die transparente organische Schicht (121; 221, 251; 321; 821) eine transparente organische Unterschicht (1210; 2210, 2510; 3210; 8210) aufweist, die zwischen der ersten transparenten anorganischen Sperrschicht (120; 220, 250; 320; 820) und den Getter-Punkten (1211; 2211, 2511; 3211; 8211) bereitgestellt ist.

3. Licht-emittierende Vorrichtung (1; 2) nach Anspruch 1, wobei die erste transparente anorganische Sperrschicht (120; 220, 250; 320; 820) näher an dem Substrat (10; 20) bereitgestellt ist als die zweite transparente anorganische Sperrschicht (122; 222, 252; 322; 822), wobei die transparente organische Schicht (121; 221, 251; 321; 821) eine transparente organische Planarisierungsschicht (1212; 2212, 2512; 3212; 8212) aufweist, die die Getter-Punkte (1211; 2211; 2511; 3211; 8211) einbettet und eine planare Fläche an einer Seite gegenüberliegend der ersten transparenten anorganischen Sperrschicht (120; 220, 250; 320; 820) bildet.

4. Licht-emittierende Vorrichtung (1; 2) nach Anspruch 1, wobei die Sperrschicht (32) eine weitere transparente organische Schicht (323) aufweist, die zwischen der ersten transparenten anorganischen Sperrschicht (320) und der zweiten transparenten anorganischen Sperrschicht (322) bereitgestellt sind, wobei das Getter-Material auch in der weiteren transparenten organischen Schicht (323) in einem Muster von Getter-Punkten (3231) bereitgestellt ist, wobei eine weitere transparente anorganische Sperrschicht (324) zwischen der transparenten organischen Schicht (321) und der weiteren transparenten organischen Schicht (323) bereitgestellt ist.

5. Licht-emittierende Vorrichtung (1; 2) nach Anspruch 1, wobei die Getter-Punkte (1211; 2211, 2511; 3211; 8211) einen Füllungsgrad von weniger als 20 %, bevorzugt weniger als 10 %, besonders bevorzugt weniger als 5 % haben.

6. Licht-emittierende Vorrichtung (1; 2) nach Anspruch 1, wobei die Höhe der Getter-Punkte (1211; 2211, 2511; 3211; 8211) von 10 nm bis 20 µm reicht und/oder wobei die Größe der Getter-Punkte (1211; 2211, 2511; 3211; 8211) von 5 µm bis 200 µm reicht.

## Revendications

1. Dispositif émettant de la lumière (1; 2), comprenant
- un substrat (10; 20) ;
- un agencement de conversion courant/lumière (11; 21; 81) comprenant un matériau de conversion courant/lumière (111; 211; 811) prévu entre une première couche d'électrode (110; 210; 810) et une seconde couche d'électrode (112; 212; 812), et
- une couche barrière (12; 22; 25; 32; 82) comprenant une couche organique transparente (121; 221; 251; 321; 821) fournie entre une première couche barrière inorganique transparente (120; 220; 250; 320; 820) et une seconde couche barrière inorganique transparente (122; 222; 252;322; 822), la couche barrière (12; 22, 25; 32; 82) étant prévue sur un côté de l'agencement de conversion courant/lumière (11; 21; 81) face au substrat (10; 20) et/ou entre le substrat (10; 20) et l'agencement de conversion courant/lumière (11; 21; 81),
dans lequel un matériau de getter est prévu dans la couche organique transparente (121; 221, 251; 321; 821) suivant un motif de points de getter (1211; 2211, 2511; 3211; 8211),
**caractérisé en ce que**
l'agencement de conversion courant/lumière (11; 21; 81) forme une structure avec des régions émettant de la lumière (8110) et des régions n'émettant pas de lumière (8111) du matériau de conversion courant/lumière (811) ;
dans lequel la couche barrière (12; 22, 25; 32; 82) forme une couche miroir avec des régions non transparentes (8213) alignées avec les régions émettant de la lumière (8110) du matériau de conversion courant/lumière (811) et des régions transparentes (8214) alignées avec les régions n'émettant pas de lumière (8111) du matériau de conversion courant/lumière (811), et
dans lequel les régions non transparentes (8213) sont formées par les points de getter (1211; 2211, 2511; 3211; 8211).

2. Dispositif émettant de la lumière (1; 2) selon la revendication 1, dans lequel la première couche barrière inorganique transparente (120; 220; 250; 320; 820) est prévue de manière plus proche du substrat (10; 20) que de la seconde couche barrière inorganique transparente (122; 222; 252;322; 822), dans lequel la couche organique transparente (121; 221, 251; 321; 821) comprend une couche sous-jacente organique transparente (1210; 2210, 2510; 3210; 8210) prévue entre la première couche barrière inorganique transparente (120; 220; 250; 320; 820) et les points de getter (1211; 2211, 2511; 3211; 8211).

3. Dispositif émettant de la lumière (1; 2) selon la revendication 1, dans lequel la première couche barrière inorganique transparente (120; 220; 250; 320; 820) est prévue de manière plus proche du substrat (10; 20) que de la seconde couche barrière inorganique transparente (122; 222; 252;322; 822), et dans lequel la couche organique transparente (121; 221, 251; 321; 821) comprend une couche de planarisation organique transparente (1212; 2212, 2512; 3212; 8212) qui intègre les points de getter (1211; 2211, 2511; 3211; 8211) et forme une surface plane sur un côté opposé à la première couche barrière inorganique transparente (120; 220; 250; 320; 820).

4. Dispositif émettant de la lumière (1; 2) selon la revendication 1, dans lequel la couche barrière (32) comprend en outre une couche organique transparente supplémentaire (323) prévue entre la première couche barrière inorganique transparente (320) et la seconde couche inorganique transparente (322); dans lequel le matériau de getter est également prévu dans la couche organique transparente supplémentaire (323) suivant un motif de points de getter (3231), et dans lequel une couche barrière inorganique transparente supplémentaire (324) est prévue entre la couche organique transparente (321) et la couche organique transparente supplémentaire (323).

5. Dispositif émettant de la lumière (1; 2) selon la revendication 1, dans lequel les points de getter (1211; 2211, 2511; 3211; 8211) présentent un facteur de remplissage inférieur à 20%, de préférence inférieur à 10 %, et plus préférablement inférieur à 5 %.

6. Dispositif émettant de la lumière (1; 2) selon la revendication 1, dans lequel la hauteur des points de getter (1211; 2211, 2511; 3211; 8211) s'étend de 10 nm à 20 µm, et/ou dans lequel la taille des points de getter (1211; 2211, 2511; 3211; 8211) s'étend de 5 µm à 200 µm.
